# EUROPEAN PATENT APPLICATION

(11) **EP 4 567 797 A1**
(43) Date of publication of application: **11.06.2025**
(21) Application number: 23215118.3
(22) Date of filing: 08.12.2023
(51) Int. Cl.: G11C 5/02, G11C 11/4097, G11C 11/4094, G11C 5/06, G11C 7/12, G11C 7/18, G11C 8/14, H10B 12/00, G11C 8/12, G11C 11/408, G11C 11/4091

(54) **A 3D DRAM WITH BIT LINE SELECT AND PRE-CHARGE TRANSISTORS**

(71) Applicant: Imec VZW, 3001 Leuven (BE); Katholieke Universiteit Leuven KU Leuven Research & Development, 3000 Leuven (BE)
(72) Inventor: Oh, Hyungrock, 1200 Brussels (BE); Wang, Bowen, 3001 Leuven (BE); Rassoul, Nouredine, 1440 Braine le Chateau (BE); Gupta, Mohit, 3001 Heverlee (BE)
(74) Representative: Roth, Sebastian

(57) **Abstract**

The present disclosure relates to a 3D dynamic random access memory (3D DRAM). The DRAM comprises a block with a 3D array of memory cells. The block comprises a set of planes stacked along a first axis, including a subset of consecutively stacked planes. Each plane of the subset comprises a 2D array of memory cells organized in rows and columns. The block is divided into multiple sub-blocks arranged along the second axis, each sub-block containing one column of memory cells of each plane. The DRAM further comprises a plurality of bit lines extending along the first axis in one of the sub-blocks and connected to one memory cell in each plane, and comprises a plurality of global bit lines connected to the bit lines in each sub-block. A plurality of bit line selector (BLS) transistors, of the DRAM are configured to respectively connect one of the bit lines to one of the global bit lines. A plurality of bit line pre-charge (BLP) transistors of the DRAM are respectively configured to connect one of the bit lines to one of a plurality of charging lines to charge the bit line.

## Description

### TECHNICAL FIELD

The present disclosure relates to dynamic random access memory (DRAM). In particular, this disclosure proposes a 3D DRAM, that is, a DRAM with a 3D array of memory cells. The 3D DRAM of this disclosure comprises bit line selector (BLS) transistors and bit line pre-charge (BLP) transistors.

### BACKGROUND

Currently, there are difficulties in making DRAM smaller while increasing its storage capacity. In particular, DRAM scaling is facing challenges in terms of reducing the memory cell area, increasing the memory cell density, and achieving higher aspect ratios in the vertical direction of the memory cell. There have been various approaches for creating 3D DRAM to address these difficulties. However, most of these conventional approaches concentrate only on the individual memory bit cells and their organization into a memory cell array, while not considering the connections between the memory cells and the core circuits, like sense amplifiers and word line drivers.

A first challenge arises from a size discrepancy between the smaller bit line pitch and the larger bit line sense amplifier (BLSA). For example, for advanced DRAM technology, the bit line pitch is about ~3.4F (44nm), while the area of a BLSA is estimated to be 284F2 (88nm by 6.25µm). For a 2D DRAM, one BLSA can be located between two bit line pitches, on either side of an array block (MAT). In this setup, multiple BLSAs are arranged similarly to the bit lines in one direction (either x-direction or y-direction). However, for a 3D DRAM, the bit lines are arranged in two directions (in both x-direction and y-direction), which restricts the placement and routing of the BLSAs. This affects the performance and area efficiency of the 3D DRAM.

A second challenge arises from the number of BLSAs. For a 2D DRAM, each bit line is connected to a BLSA, and all the memory cells on a word line operate simultaneously by word line activation. In other words, there should be an equal number of BLSAs and bit lines in the MAT, which leads to an increased area consumption. Transferring this kind of configuration (i.e., one bit line to one BLSA) to a 3D DRAM is problematic, because it brings about issues with the placement and connection to the BLSA, and also leads to a larger area consumption.

### SUMMARY

Generally, an objective of this disclosure is therefore to provide an improved 3D DRAM. Particularly, an objective is to reduce the area consumption in view of the above-described issues. Another objective is to reduce the parasitic loading in the 3D DRAM. Another objective is to reduce the number of word line drivers in the 3D DRAM. To this end, the disclosure has the objective to provide both a 3D DRAM memory cell array architecture, and a way to connect the 3D DRAM memory cell array to sense amplifiers and word line drivers, respectively. Thereby, the disclosure aims for a one transistor and one capacitor (1T1C) memory cell configuration.

These and other objectives are achieved by the solutions of this disclosure as described in the independent claims. Advantageous implementations of these solutions are described in the dependent claims.

A first aspect provides a DRAM comprising: a block comprising a 3D array of memory cells; wherein the block comprises a set of planes stacked along a first axis, wherein the set of planes comprises a subset of consecutively stacked planes, and wherein each plane of the subset of planes comprises a 2D array of memory cells organized in rows extending along a second axis perpendicular to the first axis and columns extending along a third axis perpendicular to the first and the second axis; and wherein the block is divided into multiple sub-blocks arranged along the second axis, each sub-block containing one column of memory cells of each plane of the subset of planes; the DRAM further comprising: a plurality of bit lines, wherein each bit line extends along the first axis in one of the sub-blocks and is connected to one memory cell in each plane of the subset of planes; a plurality of global bit lines, wherein one or more of the global bit lines are connected to the bit lines in each sub-block; a plurality of BLS transistors, wherein each BLS transistors is configured to connect one of the bit lines to one of the global bit lines; and a plurality of BLP transistors, wherein each BLP transistor is configured to connect one of the bit lines to one of a plurality of charging lines in order to charge the bit line.

The DRAM of the first aspect, having the 3D array of memory cells, is a 3D DRAM. The 3D DRAM may block-addressable, and may even be sub-block-addressable. This can be beneficial for its performance, endurance, and energy efficiency, and also its storage density may be increased.

The 3D DRAM of the first aspect comprises so-called vertical bit lines, as they extend along the first axis, which is considered to be the vertical axis in this disclosure. The connection of the vertical bit lines to the global bit lines reduces the area consumption, as a more relaxed placement and routing of sense amplifiers is possible. Additionally, a parasitic bit line loading can be reduced in the 3D DRAM of the first aspect.

Moreover, also a reduced parasitic loading on the global bit lines can be achieved in the DRAM of the first aspect. In particular, the BLS and BLP transistor scheme is proposed for this reason. The reduced parasitic loading achieved by the use of the BLS and BLP transistors is even independent of the number of planes of the DRAM. The BLS transistor allow loading only charge of selected bit lines to the corresponding global bit line. The BLP transistor pre-charge the bit lines to minimize the effects of parasitic capacitances, which may lead to a faster and more energy-efficient memory operation. For example, the pre-charging may involve setting the bit line to a known voltage level, for instance, halfway between the logical '0' and '1'. This may reduce the required voltage swing during read and/or write operations.

The BLS and BLP transistors can be implemented in the memory cell array region, respectively, with the same configuration as the memory cells in the memory cell array region. For example, the BLS and BLP transistors may respectively be modified memory cells, of which the storage capacitor is removed. Accordingly, less area consumption can also be projected.

In an implementation, one plane of the set of planes comprises a 2D array of BLS transistors.

In an implementation, one plane of the set of planes comprises a 2D array of BLP transistors.

Integrating the BLS and BLP transistors as arrays in respective planes allows reducing the area consumption. Moreover, fabrication benefits are achieved, as the BLS and BLP transistors can be processed to a large extent together with the memory cells.

In an implementation, the plane that includes the 2D array of BLP transistors is arranged on the subset of planes, wherein each BLP transistor is associated with one of the bit lines; and the plane that includes the 2D array of BLS transistors is arranged on the plane that includes the 2D array, wherein each BLS transistor is associated with one of the bit lines.

The BLS and BLP transistor may be either arranged at the top or the bottom of the memory cell array.

In an implementation, each BLS transistor is connected with one of its two terminals to the one of the global bit lines, and is connected with its gate to one of a plurality of first select lines.

In an implementation, each BLP transistor is connected with one of its two terminals to the one of the charging lines, and is connected with its gate to one of a plurality of second select lines.

The select lines can accordingly be used, during operation of the 3D DRAM, to operate the BLS transistors and BLP transistors, respectively. This operation selects bit lines and pre-charges bit lines.

In an implementation, the DRAM further comprises a plurality of sense amplifiers, wherein each sense amplifier is connected to one of the global bit lines.

This reduces the area consumption, as a more relaxed placement and routing of the sense amplifiers is possible.

In an implementation, each global bit line extends along the third axis, and is associated with one respective sub block, and is connected to a respective group of bit lines or to all of the bit lines in the respective sub-block.

In an implementation, the DRAM further comprises a plurality of word lines, wherein each word line extends in one of the planes along the second axis, and is connected to one memory cell in each sub-block.

In an implementation, the DRAM further comprises a single word line driver shared among all the word lines; or multiple word line drivers, wherein each word line driver is shared among all the word lines of the same plane; and in addition to the single or multiple word line drivers, one or more word line selectors configured to selectively connect the one or more word line drivers to the word lines.

In this way, the number of word line drivers may be reduced. This may lead to a reduction of the area consumed by word line drivers as well.

In another implementation, the DRAM further comprises a plurality of word line drivers, which are directly connected to the plurality of word lines.

In another implementation, the DRAM further comprises: a single word line selector shared among all the word lines; or multiple word line selectors, wherein each word line selector is shared among all the word lines of the same plane; wherein the one or more word line selectors are configured to selectively connect an output of an address decoder to a plurality of word line drivers; and wherein the plurality of word line drivers are connected to the plurality of word lines.

In this way, the number of word line selectors may be reduced. This may lead to a reduction of the area consumed by word line selectors as well. In this implementation, the one or more word line selectors are arranged and connected between the address decoder and the word line drivers. The address decoder may function as a first decoder, and the one or more word line selectors may function as a second decoder. The address decoder may be an address decoder used in a conventional DRAM. The address decoder maybe a circuit that interprets memory addresses received, for example, form a central processing unit (CPU) to select where data is to be read or written in the memory array. The word line drivers could be inverters, for instance.

A second aspect of this disclosure provides a method for processing a dynamic random access memory, DRAM, the method comprising: forming a block comprising a 3D array of memory cells; wherein the block comprises a set of planes stacked along a first axis, wherein the set of planes comprises a subset of consecutively stacked planes, and wherein each plane of the subset of planes comprises a 2D array of memory cells organized in rows extending along a second axis perpendicular to the first axis and columns extending along a third axis perpendicular to the first and the second axis; and wherein the block is divided into multiple sub-blocks arranged along the second axis, each sub-block containing one column of memory cells of each plane of the subset of planes; the method further comprising: forming a plurality of bit lines, wherein each bit line extends along the first axis in one of the sub-blocks and is connected to one memory cell in each plane of the subset of planes; forming a plurality of global bit lines, wherein one or more of the global bit lines are connected to the bit lines in each sub-block; forming a plurality of BLS transistors, wherein each BLS transistors is configured to connect one of the bit lines to one of the global bit lines; and forming a plurality of BLP transistors, wherein each BLP transistor is configured to connect one of the bit lines to one of a plurality of charging lines in order to charge the bit line.

In an implementation, a 2D array of BLS transistors is formed in one of the planes of the set of planes, and wherein a 2D array of BLP transistors is formed in another one of the planes of the set of planes.

In an implementation, forming the 2D array of BLS transistors and/or the 2D array of BLP transistors comprises, respectively: forming a 2D array of dummy memory cells in the one of the planes, wherein each dummy memory cell comprises a transistor connected with one of its two terminals to a capacitor; removing or shorting the capacitor of each dummy memory cell in the one of the planes; and connecting the terminal of the transistor of each dummy memory cell to the global bit line or charging line, respectively.

The method of the second aspect leads to the 3D DRAM of the first aspect, and may have implementations to produce all the implementations of the DRAM of the first aspect. The method of the second aspect thus brings forth the same advantages as described above regarding the first aspect.

A third aspect of this disclosure provides a method for operating a DRAM of the first aspect or any of its implementations, the method comprising: selecting a bit line by activating the BLS transistor associated with the bit line, so as to connect the bit line to the associated global bit line; pre-charging the bit line by activating the BLP transistor associated with the bit line, so as to connect the bit line to the associated charging line; and sensing a charge on the associated global bit line, which is connected via the BLS transistor to the bit line, or providing a charge on the global bit line.

In an implementation, the method further comprises driving a word line of the DRAM to activate a memory cell connected to the bit line, so as to transfer data stored in the capacitor of the memory cell between the memory cell and the bit line; wherein the word line is driven before, after, or at the same time as selecting and pre-charging the bit line.

The method of the third aspect reduces the effects of parasitic capacitances in the 3D DRAM, and therefore allow reducing the loading on the global bit lines.

In summary of the above aspects and implementations, this disclosure introduces the BLS transistors and the BLP transistors in a 3D DRAM architecture having vertical bit lines. The disclosure explores the memory core architecture, while considering connections between the bit lines and the sense amplifiers via global bit lines, and reduces both the bit line and global bit line parasitic loadings. Also the impact of increasing the number of planes is minimized, for instance, on the area of the sense amplifiers and the respective parasitic loadings.

### BRIEF DESCRIPTION OF THE DRAWINGS

The above described aspects and implementations are explained in the following description of embodiments with respect to the enclosed drawings:
- FIG. 1: shows a perspective view and a top view of a 3D DRAM according to this disclosure with vertical bit lines, BLS transistors, and BLP transistors.
- FIG. 2: shows a front view of an exemplary 3D DRAM according to this disclosure.
- FIG. 3: shows a first perspective view of the exemplary 3D DRAM.
- FIG. 4: shows a second perspective view of the exemplary 3D DRAM.
- FIG. 5: shows a top view of the exemplary 3D DRAM.
- FIG. 6: shows a method of operating a 3D DRAM according to this disclosure.
- FIG. 7: shows possible timing diagrams for the method of operating the 3D DRAM.
- FIG. 8: shows method of fabricating a 3D DRAM according to this disclosure.

### DETAILED DESCRIPTION OF EMBODIMENTS

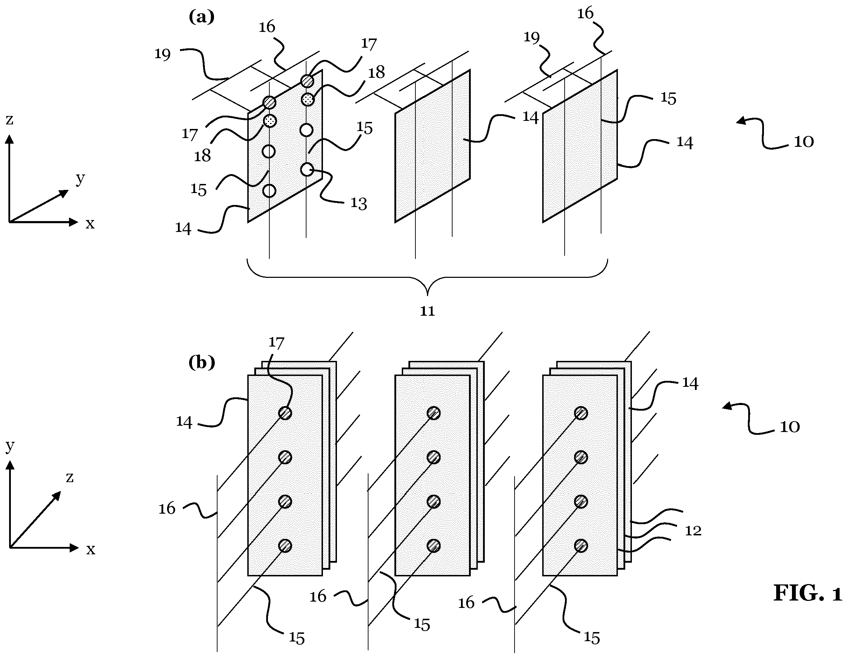

FIG. 1 shows a DRAM 10 according to this disclosure. In particular, FIG. 1(a) shows a perspective view of the DRAM 10, while FIG. 1(b) shows a top-view of the DRAM 10. The DRAM 10 is a 3D DRAM, as it comprises a block 11 including a 3D array of memory cells 13. The DRAM 10 may comprise more than one such block 11, i.e., it may comprise an arrangement of multiple blocks 11, which may be individually addressable. Each block 11 may be identical. The following description relates to one block 11. The memory cells 13 may each comprise a storage capacitor to store data in the form of charge, and a transistor connected to the storage capacitor and configured to enable writing of data to the storage capacitor or reading data from the storage capacitor. Each memory cell 13 may be able to store one bit of data (information). The memory cells 13 in the 3D DRAM 10 may be arranged in rows, columns, and stacks.

In particular, as shown in FIG. 1(b), the block 11 of the DRAM 10 comprises multiple planes 12, which are stacked along a first axis (the vertical axis in this disclosure, which is the z-axis according to the coordinate system shown in the figures). As derivable from FIG. 1, each plane 12 comprises a 2D array of memory cells 13, which are organized in rows extending along a second axis perpendicular to the first axis (the second axis is the x-axis in the coordinate system) and columns extending along a third axis perpendicular to the first and the second axis (the third axis is the y-axis in the coordinate system). The stacked planes 13 accordingly include columns, rows, and stacks of memory cells 13, wherein stacks of memory cells 13 comprise memory cells 13 arranged along the first axis.

As further schematically shown in FIG. 1(a) and 1(b), the block 11 is divided into multiple sub-blocks 14, which are arranged along the second axis. Each sub-block 14 contains one column of memory cells 13 of each plane 12. The consecutive arrangement of the sub-blocks 14 defines the rows of memory cells 13 along the second axis. Each sub-block 14 may be individually addressable in the DRAM 10. The DRAM 10 also comprises a plurality of bit lines 15. Each bit line 15 extends along the first axis in one of the sub-blocks 14. The bit lines 15 are thus referred to as vertical bit lines in this disclosure. Each bit line 15 is connected to one memory cell 13 in each plane 12. That is, each bit line 15 is connected to a stack of memory cells 13.

Moreover, the DRAM 10 includes a plurality of global bit lines 16. One or more of the global bit lines 16 are connected to the bit lines 15 in each sub-block 14. Just as an example, the illustration in FIG. 1 shows one global bit line 16 per sub-block 14, wherein the global bit line 16 is connected to all the shown bit lines 15 of said sub-block 14. However, it is also possible that two or more global bit lines 16 are used to connect to the bit lines 15 of a respective sub-block 14.

The DRAM 10 of FIG. 1 also includes a plurality of BLS transistors 17 and a plurality of BLP transistors 18. Each BLS transistor 17 is configured to connect one of the bit lines 15 to one of the global bit lines 16. Each BLP transistor 18 is configured to connect one of the bit lines 15 to one of a plurality of charging lines 19, and may be operated (opened) to charge the bit line 15. For instance, the bit line 15 may be precharged to a known voltage level between the voltages of the logical 'o' and '1'. Accordingly, such a voltage may be applied to the charging line 19 for pre-charging the bit line 15.

One particular plane 12 of the set of planes 12 may comprise a 2D array of BLS transistors 17, and one other particular plane 12 of the set of planes 12 may comprise a 2D array of BLP transistors 18. Each sub-block 14 may comprise a column of BLS transistors 17 and may comprise another column of BLP transistors 18, which are respectively associated with one bit line 15 in the sub-block 14.

In the following, more specific examples of the DRAM 10 according to this disclosure are presented. These examples are all based on the DRAM 10 shown in FIG. 1. Same elements in FIG. 1 and any one of the previous figures share the same reference signs, and may be implemented and/or function likewise. Redundant description is avoided.

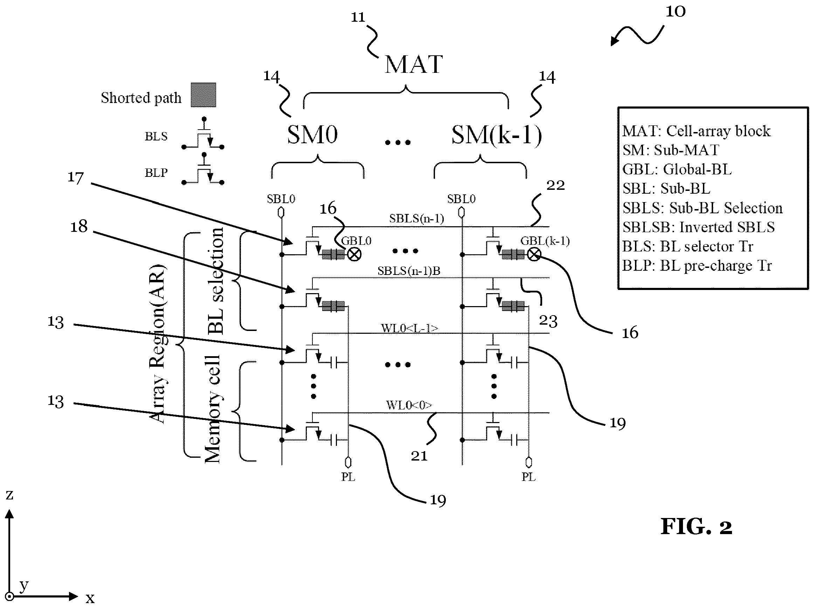

FIG. 2 shows a front/side view of an exemplary DRAM 10 according to this disclosure. In the DRAM 10 of FIG. 2, the block 11 is called a "MAT" (cell array block), and the multiple sub-blocks 14 are respectively called "Sub-MAT" or short "SM". The sub-blocks 14 are numbered SM0 to SM(k-1), wherein an example is k=32. Accordingly, each block 11 may be composed of 32 sub-blocks 14 in such an example. Moreover, each sub-block 14 comprises vertical bit lines 15, for instance, 32 vertical bit lines 15. In FIG. 2, one bit line (BL) that is called and numbered SBL0 is shown per sub block 14.

FIG. 2 shows further that the DRAM 10 comprises a plurality of word lines 21. Each word line 21 may extend in one of the stacked planes 12 along the second axis. Thereby, each word line 21 is connected to one memory cell 13 in each of the multiple sub-blocks 14. If the word line 21 is operated (charged), the memory cells 13 connected to the word line 21 may be activated. For instance, the transistor connected to the storage capacitor of the memory cell 13 may be turned on (opened), in order to allow charge to be written to or read from the storage capacitor. Reading and writing may be conducted via the bit line 15 connected to this memory cell 13. As an example, there may be 32 word lines 21 for each of 32 planes of the DRAM 10. In FIG. 2, the word lines 21 are called and numbered WL0<0> to WL0<L-1>, wherein <#> denotes the particular plane with number # and L=32 is an example.

FIG. 2 shows also the plurality of global bit lines 16 of the DRAM 10, wherein each global bit lines 16 is connected to a terminal of a BLS transistors 17. That is, each BLS transistor 17 is connected with one of its two terminals to one of the global bit lines 16 The global bit lines 16 are numbered GBL0 to GBL(k-1) in this example.

The BLS transistors 17 are arranged in the uppermost plane 12 in FIG. 2. Each BLS transistor 17 is configured to connect one of the bit lines 15 to one of the global bit lines 16. The BLS transistors 17 may thereby be operated by a plurality of first select lines 22, wherein one first select line 22 called SBLS(n-1) (for "Sub-BL Selection") is shown in FIG. 2. Each BLS transistor 17 is connected with its gate to one of the plurality of first select lines 22. The BLP transistors 18 are arranged in the second plane 12 from the top, i.e., they are arranged between the plane 12 comprising the BLS transistors 17 and the subset of planes 12 comprising the memory cells 13. The two planes 12 comprising respectively the BLS and BLP transistors 17, 18 are referred to as BL selection region, while the remaining planes 12 are referred to as Memory cell region. Together they may form the Array Region (AR). That is, the plane 12 that includes the BLP transistors 18 may be arranged on the subset of planes 12 including the memory cells 13, and the plane 12 that includes the BLS transistors 17 may be arranged on the plane 12 that includes the BLP transistors 18.

Each BLP transistor 18 is associated with one of the bit lines 15, and each BLS transistor 17 is associated with one of the bit lines 15. In particular, each BLP transistor 18 is configured to connect one of the bit lines 15 to one of a plurality of charging lines 19, in order to charge the bit line 15. The charging lines are abbreviated PL in FIG. 2. To this end, each BLP transistor 18 is connected with one of its two terminals to one of the charging lines 19. Moreover, each BLP transistor 18 is connected with its gate to one of a plurality of second select lines 23. The plurality of second select lines 23 can be used to operate the BLP transistors, wherein one second select line 23 called SBLS(n-1)B (for Inverted SBLS) is shown in FIG. 2. The first and second select lines 22, 23 may be controlled together, wherein the second select line 23 is operated inverted compared to the first select line 22.

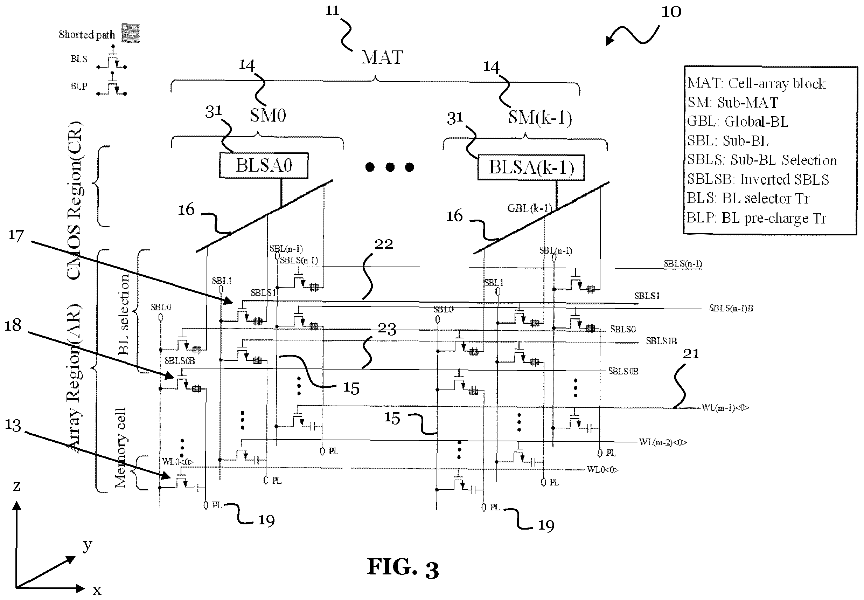

FIG. 3 shows a first perspective view of the exemplary DRAM 10, wherein FIG. 3 highlights one plane 12 of the DRAM 10, and the connections between the first select lines 22 and the BLS transistors 17, and the second select lines 23 and the BLP transistors. The first select lines 22 are labelled SBLS0 to SBLS(n-1), and the second select lines 23 are labelled SLS0B to SLS(n-1)B, wherein an example is n=32. Each first select line 22 may be used to operate one BLS transistor 17 of each sub-block 14. Each second select line 23 may be used to operate one BLP transistor 18 of each sub-block 14.

As shown further in FIG. 3, the DRAM 10 further comprise a plurality of bit line sense amplifiers 31 (BLSA). Each sense amplifier 31 is connected to one of the global bit lines 16, and is configured to sense (detect) a charge on that global bit line 16. Indirectly, each sense amplifier 31 may thus be connected to - via said global bit line 16 - to multiple bit lines 15, and may thus be able to detect charge coming from at least one bit line 15 onto the global bit line 16. It may be possible in the DRAM 10 to read charge of a single memory cell 13 per sub-block 14 using the bit line 15, global bit line 16 and sense amplifier 31. The sense amplifiers 31 are labelled BLSA0 to BLSA(k-1) in FIG. 3.

In order to improve the connection between the bit lines 15 and the sense amplifiers 31 in this example - while taking into account the smaller bit line pitch - all the bit lines 15 in each sub-block 14 are connected to a single global bit line 16. Each global bit line 16 extends along the third axis in this example, and is associated with one respective sub block 14 of the multiple sub-blocks 14. Each global bit line 16 is connected to all the bit lines 15 in said respective sub-block 14. Each global bit line 16 is connected to one sense amplifier 31.

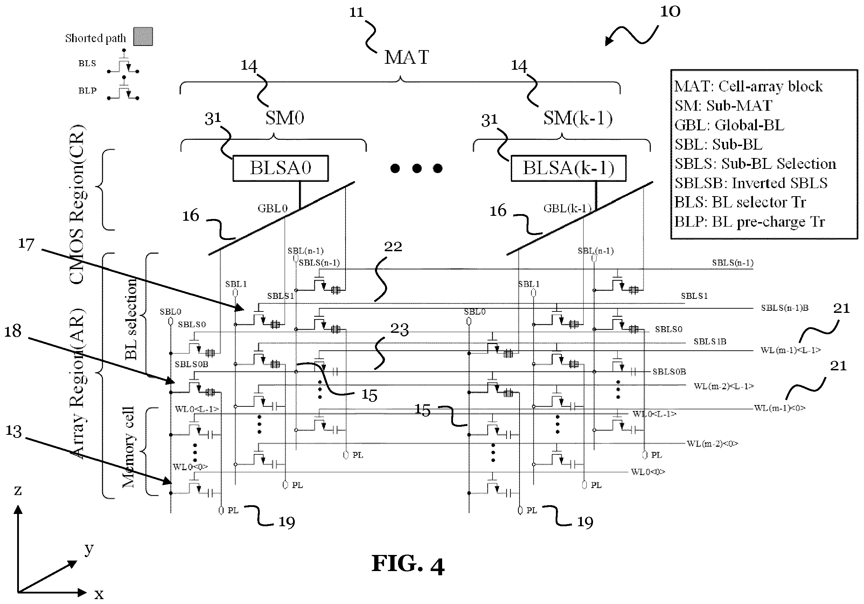

FIG. 4 shows a second perspective view of the exemplary DRAM, wherein FIG. 4 highlights multiple planes 12 of the DRAM 10. FIG. 4 shows the connections between the first select lines 22 and the BLS transistors 17, and the second select lines 23 and the BLP transistors like in FIG. 3. FIG. 4 further shows the connection of the storage transistors of the memory cells 13 to the word lines 21. In particular, the word lines W0<L-1> to WL(m-1)<L-1> are shown, wherein an example is m=32. There may be 32 word lines W0 to WL(m-1) in each of 32 planes <0> to <L-1>.

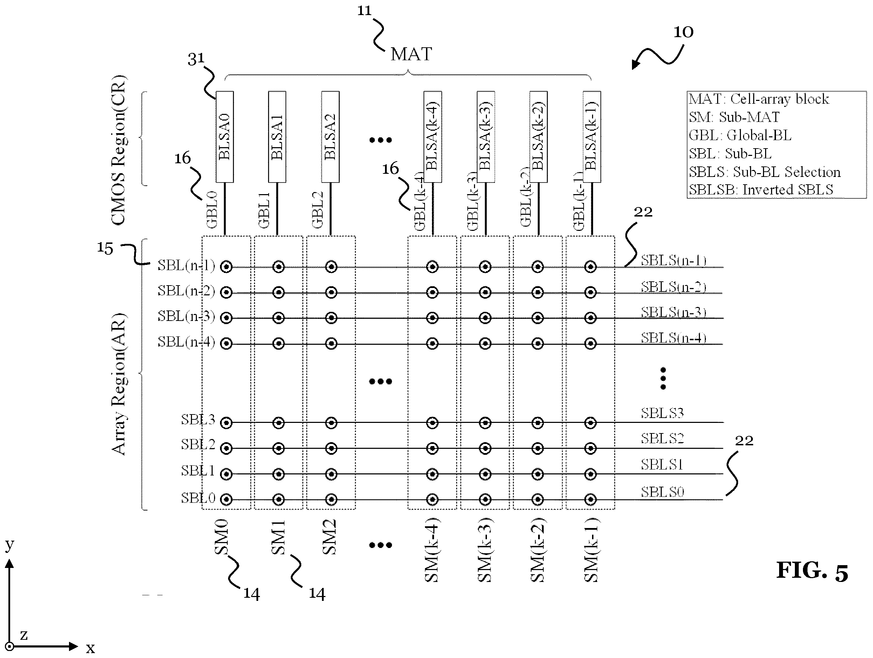

FIG. 5 shows a top view of the exemplary DRAM 10. In particular, FIG. 5 shows only one plane 12 of the plurality of planes 12 of the DRAM 10. FIG. 5 shows how the bit lines 15 are connected, on the one hand, to the memory cells 13 of the 2D array of that plane 12 and, on the other hand, to the global bit lines 16. FIG. 5 also shows how the word lines 21 are connected to the memory cells 13 of the 2D array of that plane 12. In this example, the global bit lines 16 extend along the third axis, the bit lines 15 extend along the first axis, and the first and second select lines 22, 23 respectively extend along the second axis.

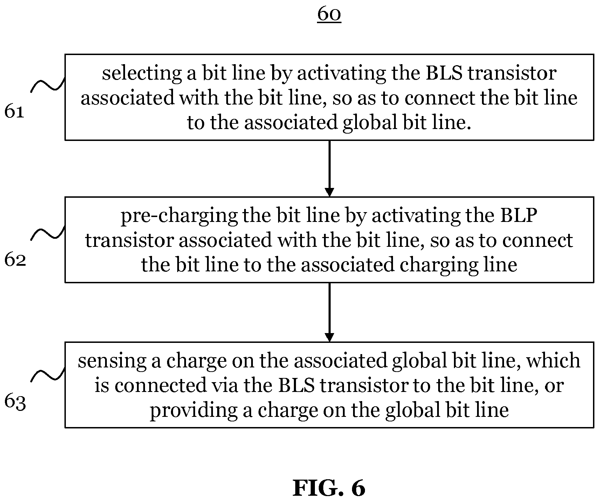

FIG. 6 shows a method 60 for operating a DRAM 10 according to this disclosure, for instance, the DRAM 10 shown in FIGs. 1-5. The method 60 comprises a step 61 of selecting a bit line 15 by activating the BLS transistor 17 associated with that bit line 15. This connects the bit line 15 to the associated global bit line 16. The method 60 further comprises a step 62 of pre-charging the bit line 15 by activating the BLP transistor 18 associated with that bit line 15. This connects the bit line 15 to the associated charging line 19. The method 60 then comprises a step 63 of sensing a charge on the associated global bit line 19, which is connected via the BLS transistor 17 to the bit line 15, or of providing a charge on the global bit line 16.

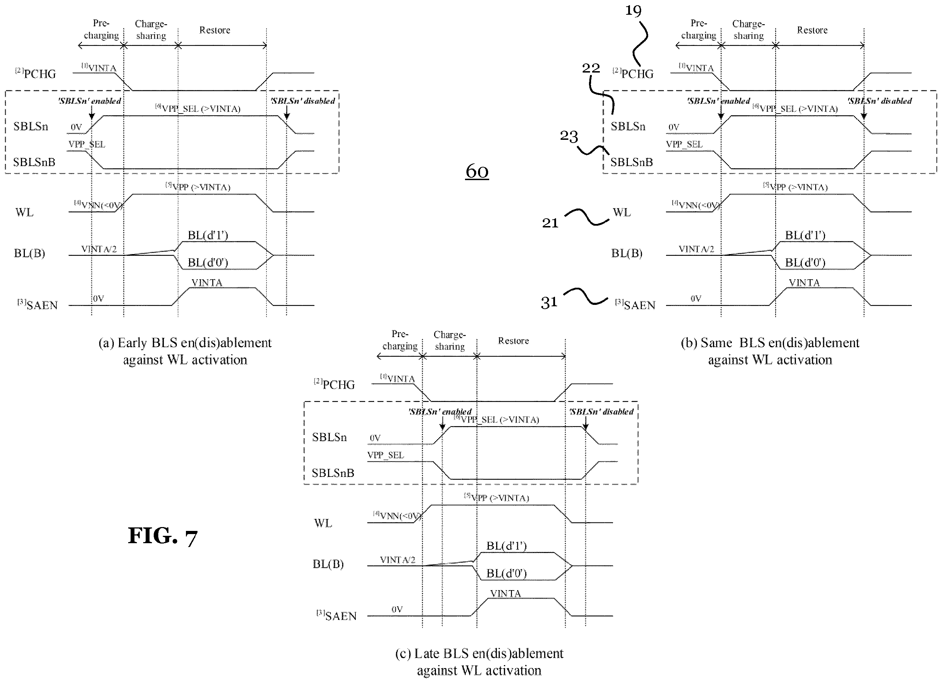

FIG. 7 shows possible timing diagrams that can be applied in the method 60 of FIG. 6. Generally, the method 60 may further comprise a step of driving a word line 21 of the DRAM 10, in order to activate a memory cell 13 connected to the bit line 15. This may lead to a transfer of data stored in the capacitor of the memory cell 13 (as charge) from the memory cell 13 to the bit line 15 (read), or may lead to a transfer of data from the bit line 15 to the memory cell 13 (write). Thereby, the word line 21 may be driven before, after, or at the same time as selecting the bit line 15 and pre-charging the bit line 15, as shown in FIG. 7.

In particular, FIG. 7(a) shows an early BLS enablement (and also disablement) compared to the word line activation. That is, the word line 21 is driven after selecting the bit line 15. It can be seen that the first select line 22 is enabled (SBLSn is raised from 0V to "high"), while also the second select line 23 is enabled (SBLSnB is lowered from "high" to 0V). By charge on the charge line 19 (PCHG is set "high"), pre-charging takes place. After enabling the first and second select lines 22, 23, the word line 21 is activated (WL to "high"). After the word line 21 is deactivated again (WL to "low"), the first and second select lines 22, 23 are disabled (SBLSn to 0V, SBLSnB to "high").

FIG. 7(b) shows the same BLS enablement (and also disablement) compared to the word line activation. That is, the word line 21 is driven at the same time as selecting the bit line 15. It can be seen that the first select line 22 is enabled (SBLSn is raised from 0V to "high"), while also the second select line 23 is enabled (SBLSnB is lowered from "high" to 0V). The word line 21 is activated (WL to "high") at the same time as activating the first select line 22 and the second select line 23. When the word line 21 is deactivated again (WL to "low"), the first select line 22 and the second select line 23 are disabled (SBLSn to 0V, SBLSnB to "high").

FIG. 7(c) shows a late BLS enablement (and also disablement) compared to the word line activation. That is, the word line 21 is driven before selecting and pre-charging the bit line 15. It can be seen that the first select line 22 is enabled (SBLSn is raised from 0V to "high"), while also the second select line 23 is enabled (SBLSnB is lowered from "high" to 0V), however, after the word line 21 is activated (WL to "high"). Before the word line 21 is deactivated again (WL to "low"), the first select line 22 and the second select line 23 are disabled (SBLSn to 0V, SBLSnB to "high").

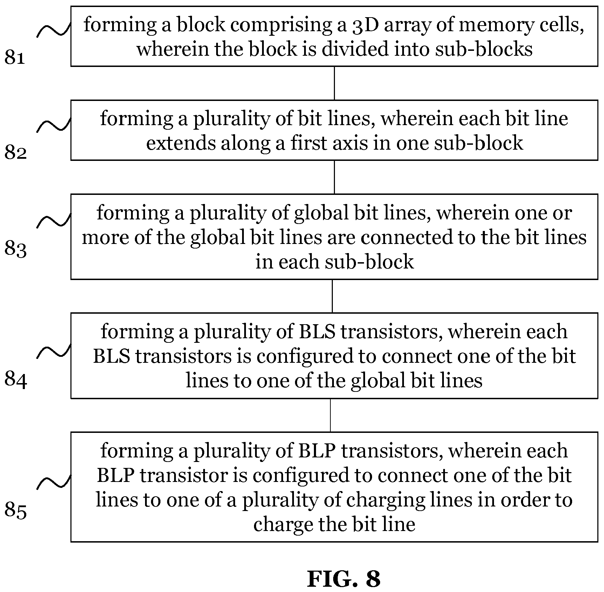

FIG. 8 shows a method 80 of fabricating a DRAM according to this disclosure, for instance the DRAM shown in the FIGs. 1-5. The method 80 comprising a step 81 of forming a block 11, wherein the block 11 comprise a 3D array of memory cells 13. The block 11 comprises a set of planes 12, which are stacked along a first axis to build the 3D array. The set of planes 12 comprises a subset of consecutively stacked planes 12, wherein each plane 12 of the subset of planes 12 comprises a 2D array of memory cells 13, so that the subset of planes 12 together forms the 3D array. The memory cells 13 of each 2D array are organized in rows extending along a second axis perpendicular to the first axis and in columns extending along a third axis perpendicular to the first and the second axis. The block 11 is also divided into multiple sub-blocks 14, which are arranged along the second axis. Each sub-block 14 contains one column of memory cells 13 of each plane 12 of the subset of planes 12.

The method 80 further comprises a step 82 of forming a plurality of bit lines 15, wherein each bit line 15 extends along the first axis in one of the sub-blocks 14, and is connected to one memory cell 13 in each plane 12 of the subset of planes 12. The method 80 also comprises a step 83 of forming a plurality of global bit lines 16, wherein one or more of the global bit lines 16 are connected to the bit lines 15 in each sub-block 14. The method 80 further comprises a step 84 of forming a plurality of BLS transistors 17, wherein each BLS transistors 17 is configured to connect one of the bit lines 15 to one of the global bit lines 16. The method 80 comprises moreover a step 85 of forming a plurality of BLP transistors 18, wherein each BLP transistor 18 is configured to connect one of the bit lines 15 to one of a plurality of charging lines 19, in order to charge the bit line 15.

Notably, the method 80 may be implemented by a processing flow to process DRAMs in general. Moreover, the steps of the method 80 do not need to be performed in the order, in which they are described, but can be adapted to the processing flow. Any order of steps may be possible, and certain steps may also be performed simultaneously or at the same stage of the processing flow.

In summary, this disclosure addresses the challenges that DRAM scaling is facing in terms of memory bit cell area, memory density, and aspect ratio in the vertical direction. The disclosure provides a 3D DRAM 10 that is designed by considering the connections between the memory cells 13 and core circuits, like sense amplifiers 17, word line drivers 22, word line selectors 22, and bit line selectors 170. The disclosure provides a solution for a 1T1C-based 3D DRAM memory cell core, and specifically introduces a way of configuring the 3D DRAM memory cell array and its connection to the sense amplifier(s) 17 and word line driver(s) 22. As a consequence, less area consumption, less parasitic bit line loadings, and less word line drivers 22 can be achieved in the DRAM 10.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A dynamic random access memory, DRAM, (10) comprising:
a block (11) comprising a 3D array of memory cells (13);
wherein the block (11) comprises a set of planes (12) stacked along a first axis, wherein the set of planes (12) comprises a subset of consecutively stacked planes (12), and wherein each plane (12) of the subset of planes (12) comprises a 2D array of memory cells (13) organized in rows extending along a second axis perpendicular to the first axis and columns extending along a third axis perpendicular to the first and the second axis; and
wherein the block (11) is divided into multiple sub-blocks (14) arranged along the second axis, each sub-block (14) containing one column of memory cells (13) of each plane (12) of the subset of planes (12);
the DRAM (10) further comprising:
a plurality of bit lines (15), wherein each bit line (15) extends along the first axis in one of the sub-blocks (14) and is connected to one memory cell (13) in each plane (12) of the subset of planes (12);
a plurality of global bit lines (16), wherein one or more of the global bit lines (16) are connected to the bit lines (15) in each sub-block (14);
a plurality of bit line selector, BLS, transistors (17), wherein each BLS transistor (17) is configured to connect one of the bit lines (15) to one of the global bit lines (16); and
a plurality of bit line pre-charge, BLP, transistors (18), wherein each BLP transistor (18) is configured to connect one of the bit lines (15) to one of a plurality of charging lines (19) in order to charge the bit line (15).

2. The DRAM (10) of claim 1, wherein one plane (12) of the set of planes (12) comprises a 2D array of BLS transistors (17).

3. The DRAM (10) of claim 2, wherein one plane (12) of the set of planes (12) comprises a 2D array of BLP transistors (18).

4. The DRAM (10) of claim 2 and 3, wherein:
the plane (12) that includes the 2D array of BLP transistors (18) is arranged on the subset of planes (12), wherein each BLP transistor (18) is associated with one of the bit lines (15); and
the plane (12) that includes the 2D array of BLS transistors (17) is arranged on the plane (12) that includes the 2D array of BLP transistors (18), wherein each BLS transistor (17) is associated with one of the bit lines (15).

5. The DRAM (10) of one of the claims 1 to 4, wherein each BLS transistor (17) is connected with one of its two terminals to the one of the global bit lines (16), and is connected with its gate to one of a plurality of first select lines (22).

6. The DRAM (10) of one of the claims 1 to 5, wherein each BLP transistor (18) is connected with one of its two terminals to the one of the charging lines (19), and is connected with its gate to one of a plurality of second select lines (23).

7. The DRAM (10) of one of the claims 1 to 6, further comprising a plurality of sense amplifiers (31), wherein each sense amplifier (31) is connected to one of the global bit lines (16).

8. The DRAM (10) of one of the claims 1 to 7, wherein each global bit line (16) extends along the third axis, and is associated with one respective sub-block (14), and is connected to a respective group of bit lines (15) or to all of the bit lines (15) in the respective sub-block (14).

9. The DRAM (10) of one of the claims 1 to 8, further comprising:
a plurality of word lines (21), wherein each word line (21) extends in one of the planes (12) along the second axis, and is connected to one memory cell (13) in each sub-block (14).

10. The DRAM (10) of claim 9, further comprising:
a single word line driver shared among all the word lines (21); or
multiple word line drivers, wherein each word line driver is shared among all the word lines (21) of the same plane (12); and
in addition to the single or multiple word line drivers, one or more word line selectors configured to selectively connect the one or more word line drivers to the word lines (21).

11. The DRAM (10) of claim 9, further comprising:
a single word line selector (23) shared among all the word lines (21); or
multiple word line selectors (23), wherein each word line selector (23) is shared among all the word lines (21) of the same plane (12);
wherein the one or more word line selectors (23) are configured to selectively connect an output of an address decoder to a plurality of word line drivers (22); and
wherein the plurality of word line drivers (22) are connected to the plurality of word lines (21).

12. A method (80) for processing a dynamic random access memory, DRAM, (10) the method (80) comprising:
forming (81) a block (11) comprising a 3D array of memory cells (13);
wherein the block (11) comprises a set of planes (12) stacked along a first axis, wherein the set of planes (12) comprises a subset of consecutively stacked planes (12), and wherein each plane (12) of the subset of planes (12) comprises a 2D array of memory cells (13) organized in rows extending along a second axis perpendicular to the first axis and columns extending along a third axis perpendicular to the first and the second axis; and
wherein the block (11) is divided into multiple sub-blocks (14) arranged along the second axis, each sub-block (14) containing one column of memory cells (13) of each plane (12) of the subset of planes (12);
the method (80) further comprising:
forming (82) a plurality of bit lines (15), wherein each bit line (15) extends along the first axis in one of the sub-blocks (14) and is connected to one memory cell (13) in each plane (12) of the subset of planes (12);
forming (83) a plurality of global bit lines (16), wherein one or more of the global bit lines (16) are connected to the bit lines (15) in each sub-block (14);
forming (84) a plurality of bit line selector, BLS, transistors (17), wherein each BLS transistors (17) is configured to connect one of the bit lines (15) to one of the global bit lines (16); and
forming (85) a plurality of bit line pre-charge, BLP, transistors (18), wherein each BLP transistor (18) is configured to connect one of the bit lines (15) to one of a plurality of charging lines (19) in order to charge the bit line (15).

13. The method (80) of claim 12, wherein a 2D array of BLS transistors (17) is formed in one of the planes (12) of the set of planes (12), and wherein a 2D array of BLP transistors (18) is formed in another one of the planes (12) of the set of planes (12).

14. The DRAM (10) of claim 13, wherein forming the 2D array of BLS transistors (17) and/or the 2D array of BLP transistors (18) comprises, respectively:
forming a 2D array of dummy memory cells in the one of the planes (12), wherein each dummy memory cell comprises a transistor connected with one of its two terminals to a capacitor;
removing or shorting the capacitor of each dummy memory cell in the one of the planes (12); and
connecting the terminal of the transistor of each dummy memory cell to the global bit line (16) or charging line (19), respectively.

15. A method (60) for operating a dynamic random access memory, DRAM, (10) of any one of the claims 1 to 10, the method (60) comprising:
selecting (61) a bit line (15) by activating the BLS transistor (17) associated with the bit line (15), so as to connect the bit line (15) to the associated global bit line (16);
pre-charging (62) the bit line (15) by activating the BLP transistor (18) associated with the bit line (15), so as to connect the bit line (15) to the associated charging line (19); and
sensing (63) a charge on the associated global bit line (19), which is connected via the BLS transistor (17) to the bit line (15), or providing a charge on the global bit line (16).

16. The method (60) of claim 15, further comprising:
driving a word line (21) of the DRAM (10) to activate a memory cell (13) connected to the bit line (15), so as to transfer data stored in the capacitor of the memory cell (13) between the memory cell (13) and the bit line (15);
wherein the word line (21) is driven before, after, or at the same time as selecting and pre-charging the bit line (15).
